# EUROPEAN PATENT APPLICATION

(11) **EP 3 410 472 A1**
(43) Date of publication of application: **05.12.2018**
(21) Application number: 17173631.7
(22) Date of filing: 31.05.2017
(51) Int. Cl.: H01L 23/367, H01L 23/373, H01L 23/40, H01L 23/42

(54) **POWER ELECTRONIC MODULE COOLING ARRANGEMENT**

(71) Applicant: ABB Schweiz AG, 5400 Baden (CH)
(72) Inventor: Hakkarainen, Henri, 00380 Helsinki (FI)
(74) Representative: Kolster Oy Ab

(57) **Abstract**

A cooling arrangement of a power semiconductor module, the arrangement comprises a power semiconductor module having a base plate, a cooling element having a cooling surface and a solid thermal interface material layer, wherein the power semiconductor module comprises two or more attachment holes and the cooling element comprises attachment holes the positions of which correspond to the attachment holes of the power semiconductor module, the attachment holes being provided for attaching the power semiconductor module to the cooling element, the thermal interface material layer is arranged between the base plate of the power semiconductor module and the cooling surface of the cooling element, wherein the edge of the thermal interface material layer is at a distance from the attachment holes and the thermal interface material layer has curved cut-outs in the positions of the attachment holes.

## Description

### FIELD OF THE INVENTION

The invention relates to a cooling arrangement, and particularly to a cooling arrangement of a power electronic module.

### BACKGROUND OF THE INVENTION

Power electronic modules are modules including multiple of switch components having substantially high current and voltage ratings. Typically, power electronic modules include controlled power semiconductors, such as IGBT components, and other semiconductors, such as diodes. These electronic components are typically electrically connected inside the module to form a circuit structure that can be used as a building block in power electronic devices. A power electronic module may, for example, include two series connected switch components with antiparallel diodes. Such a module can be used to form one phase output of an inverter. Power electronic module may also comprise switch components for a three-phase inverter and thus having six switch components with corresponding antiparallel diodes.

As the components are internally connected inside a power electronic module, the module has connection points or terminals with which the module can be connected the other circuitry of the device in which the module is used. Such connection points include control inputs for controlling the controllable components, output terminals for providing output voltage or current and input terminals for receiving input voltage or current.

The rated voltages of power electronic modules may be over 1000 Volts with currents of over 100 Amperes. Although effort is made to drive the switches in a manner producing low losses, it is inevitable that heat is generated in the module from switching losses and conduction losses of the switch components. When power electronic modules are operated at their rated values, the cooling of the module should be dimensioned carefully. Typically the cooling of the power electronic modules is carried out by attaching a cooling element to a base plate of the power electronic module. The heat generated in the module is transferred in the module to the base plate of the module from which the heat is removed with the cooling arrangement. The cooling arrangement may be a heat sink that is attached to the base plate in a thermally conducting manner.

The obtain good thermal connection, it is known to place a thermal interface material (TIM) sheet between the base plate of the power electronic module and the heat sink. Thermal interface material sheets are solid sheets which are used for ensuring that the thermal connection between the two surfaces is as good as possible. The mating surfaces of the base plate and the heat sink are not necessarily even and may have some irregularities. When placed against each other, a small air gaps are formed between the surfaces if thermal interface material is not used. Further, the use of the module may deform the base plate leading to larger gaps between the surfaces.

In attaching the power electronics module to the heatsink, the thermal interface material sheet is provided which covers the whole surface of the base plate. The heatsink is placed on the thermal interface material sheet such that the material layer is left between the two surfaces. The heatsink is attached to the power electronic module using screws or bolts. At the same time the thermal interface material is fastened between the heatsink and the module. For attaching the heatsink to the module, the module has threaded holes and the heatsink is furnished with holes in the locations corresponding to the threaded holes. Thus when the heatsink and the module are placed against each other, it is possible to attach the two with screws or bolts which penetrate through the heatsink and attach to the threads. The thermal interface material sheet has also holes in the corresponding locations such that the sheet can be attached without tearing the sheet when inserting the screws through the heatsink to the base plate of the power electronic module.

Although thermal interface material sheets improve the transfer of heat from the heat source to the heatsink, the heat transfer is still not sufficient at least in certain applications.

### BRIEF DESCRIPTION OF THE INVENTION

An object of the present invention is to provide a cooling arrangement so as to solve the above problem. The objects of the invention are achieved by a an arrangement which is characterized by what is stated in the independent claim. The preferred embodiments of the invention are disclosed in the dependent claims.

The invention is based on the idea of providing a thermal interface material sheet which, when placed between the heat source and the heat sink, has its edges at a distance from the fastening holes of the heat sink and heat source. Preferably, the sheet is a solid sheet that does not have any holes for screws or bolts. Instead of the holes, the perimeter of the sheet has cut-outs in the places of the screw holes of the heat sink. Such curved perimeter shape means that in the positions of the screw holes of the heat sink, the sheet does not extend from one edge of the heat sink to another edge.

The applicant has noticed in tests that a conventional thermal interface sheet with screw holes does not allow the heat sink and the heat source to press tightly to each other with the thermal interface material sheet when the heat sink is attached to the heat source, such as power electronics module, using screws or bolts. This is due to the fact that the base plates of the power semiconductor modules are somewhat concave so that the pressure between the base plate and the heat sink in the center area of the two is much lower than in the vicinity of the fastening holes. When a conventional thermal interface material sheet, i.e. one with holes and having a surface are that corresponds to the surface area of the heat sink and the base plate, is used, the sheet is not pressed tightly between the heat sink and the base plate in the area that is in the center of the base plate. As the contact from the heat source to the heat sink is not tight, small voids or gaps are formed weakening the thermal connection.

In the thermal interface material sheet used in the invention the screw holes are removed and cut-outs are provided in the places of screw holes. When the surfaces of the base plate and the cooling element are allowed to press against each other in the vicinity of the fastening points, the surfaces are allowed to be closer to each other. This further means that the pressure is increased in the center of the base plate and the cooling element and thereby the thermal connection between the two is enhanced. The semiconductor chips that produce the heat inside a power semiconductor module are typically situated in the area near the center of the surface area. This means that the need for good thermal connection is greatest in the center area and lowest near the screw holes.

An advantage of the arrangement of the invention is that the thermal connection between a heat source, such as power semiconductor module, and the cooling element, such as a heat sink is increased. The increased thermal connection means that more heat can be transferred from the heat source to the heat sink. Further, the arrangement of the invention is simple to implement and does not require any special tools or materials. The material of the thermal interface material sheet employed in the invention can be any known solid material that is used as thermal interface material.

### BRIEF DESCRIPTION OF THE DRAWINGS

In the following the invention will be described in greater detail by means of preferred embodiments with reference to the attached drawings, in which
Figure 1 shows an example of a base plate with attachment holes together with a thermal interface material layer;
Figure 2 shows an example of the arrangement of the invention with the power electronic module separated from the cooling element;
Figures 3 and 4 show cross-sections of an example of the arrangement of the invention;
Figure 5 shows a cross-section view of a known structure; and
Figure 6 shows a detailed cross-section view of an example of the invention.

### DETAILED DESCRIPTION OF THE INVENTION

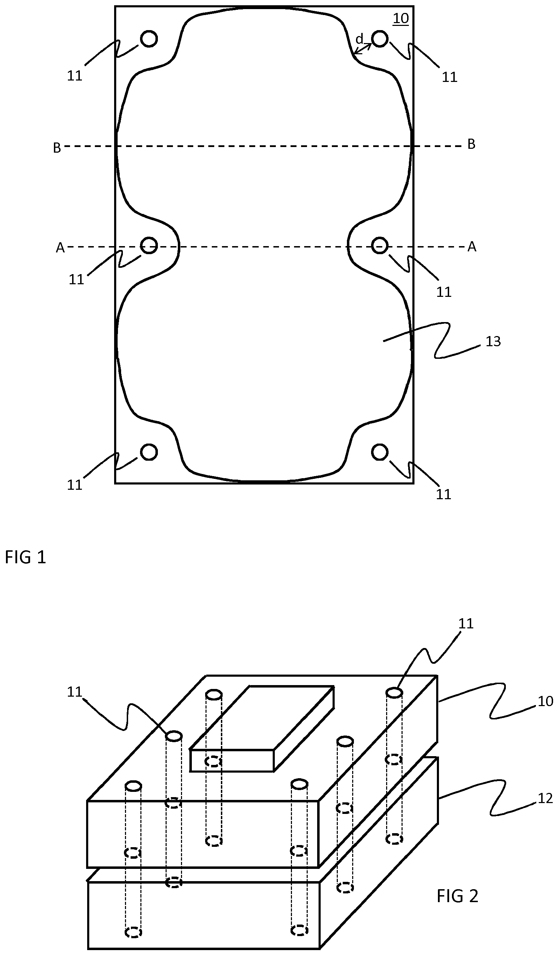

Figure 1 shows an example of a base plate of a power electronic module with attachment holes seen towards the base plate. In the example six attachment holes 11 are provided to the base plate 10. The attachment holes are provided in the example of Figure 1 to two opposing sides of the base plate and the sides are also the longer sides. The general shape of the base plate is a rectangle, i.e. the surface of the base plate has a rectangle shape. The surface of the base plate is also substantially flat so that the heat generated in the power electronic module can be transferred through the base plate to a cooling element efficiently.

For illustrating the arrangement of the invention, Figure 2 shows a perspective view of an example of the invention. In Figure 2 a power electronics module 10 is shown placed on top of a cooling element 12. The power electronic module and the cooling element are shown as separated from each other. Further, the power electronics module and the cooling element show attachment holes 11 in dashed lines through the perspective view. The attachment holes are positioned such that when placed on top of each other, the holes allow a screw or a bolt to be inserted to the holes for attaching the module 10 to the cooling element 12, such as a heat sink.

Figure 2 shows a power electronic module corresponding to that of Figure 1 in which six attachment holes are used. Figure 2 does not show a thermal interface material layer. According to the invention, the thermal material interface layer is arranged between the power electronic module and the cooling element.

In Figure 1 the thermal interface material layer is shown placed in its position on the base plate of the power electronic module. According to the invention, the edge of the thermal interface material layer is at a distance from the attachment holes and the thermal interface material layer has curved cut-outs in the positions of the attachment holes. With the edge of the thermal interface material layer it is reffered to the sides of the layer which are shown in Figure 1. The shape of the material layer does not correspond to that of the base plate as in the known structure, but is retracted in the positions of the attachment holes of the base plate. The retracted shape means further, that the surface area of the thermal interface material layer is smaller than the surface are of the base plate. Further, the thermal interface material layer is intact, i.e. it does not have any holes. According to an embodiment, the curved cut-outs form a series of curved segments, that is, multiple of cut-outs are situated at one side of the cooling arrangement.

The thermal interface material layer or sheet of the arrangement has curved cut-outs in the positions of the attachment holes. With the curved cut-outs it is referred to the shape of the material layer in that the cut-outs which are provided in places of the attachment holes of the base plate have an arc-like shape. However, the curved cut-outs can have a shape formed of straight lines which are joined together with small angles.

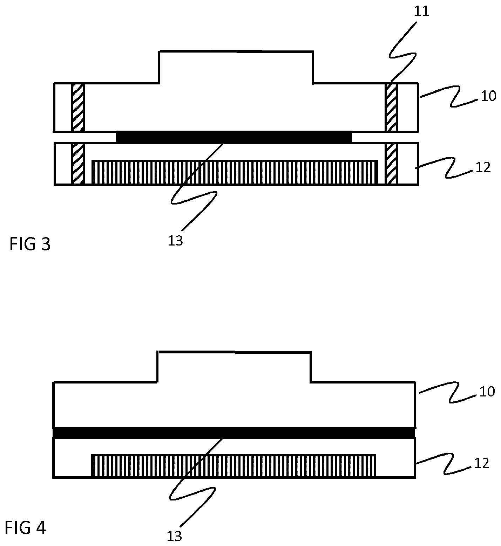

Figure 3 shows a cross section of an example of the present invention. The cross section is taken in the position of the attachment holes 11. The semiconductor module is attached to the cooling element such that a thermal interface material layer 13 is arranged between the surface of the base plate of the semiconductor module and the cooling surface of the cooling element. Figure 3 shows how the material layer is retracted from positions of the attachment holes 11. Figure 4 shows a corresponding cross section as Figure 3. In Figure 4 the cross section is taken in a position in which the thermal interface material layer extends to the sides of the base plate. The positions of the cross sections are shown in Figure 1, in which the cross section of Figure 3 is shown as line A-A and the cross seciotn of Figure 4 as line B-B. It is to be noted, that Figure 1 shows only the base plate and the thermal interface material layer and not the cooling element which is also shown in the cross sections of Figures 3 and 4.

When cut-outs are provided in the positions of the attachment holes, the distance between surface of the base plate and the surface of the cooling element is minimized and the two surfaces are pressed against each other in the vicinity of the attachment holes. As both the base plate and the cooling element are substantially rigid metal pieces or plates, the thermal interface material layer is pressed tightly between the surfaces. Further, if the base plate is bent such that the surface is concave, the distance between the surface of the base plate and the cooling surface of the cooling element is minimized when the surfaces are pressed together without the thermal interface material layer near the attachment points. The minimal distance between the surfaces in the center of the surfaces means also that the thermal interface material fills possible cavities in the best possible way.

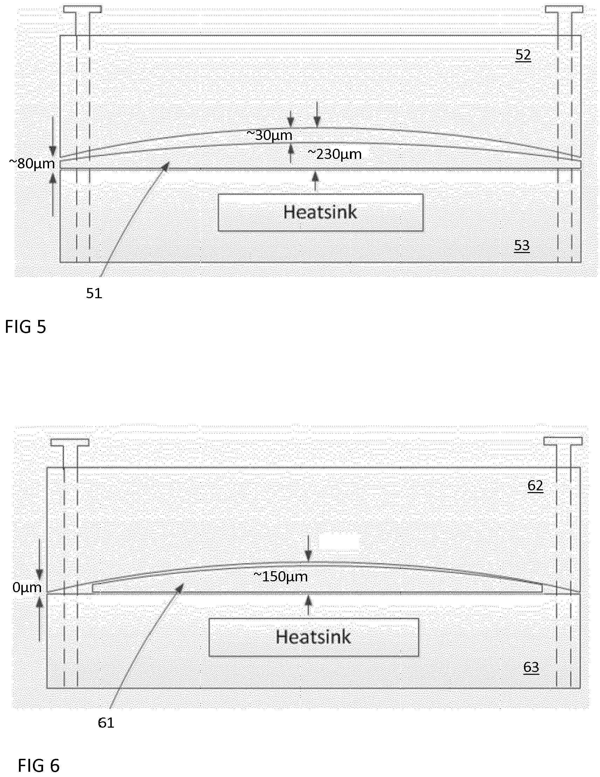

Figures 5 and 6 illustrate the shape of the base plate and the operation of the arrangement of the invention. Figure 5 shows a cross section of a conventional arrangement in which screw holes are provided to the thermal interface material layer 51 and the material layer is the same size as the surface of the base plate. Considering the maximum difference between the surfaces of the base plate 52 and the cooling element 53 is 150 µm and a thermal interface layer 51 having thickness of 200 µm is used. When the layer is of carbon based material, the maximal compression of the layer or sheet is 60%. As shown in Figure 5, when such a sheet is used, the maximal difference between the surfaces increases with 80 µm as that is the amount of compressed material in the attachment points. When the distance increases with 80 µm, the highest difference between the surfaces is 230 µm which is higher than the thickness of the sheet. Thereby the cavity is not filled with the thermal interface material as shown in Figure 5.

Figure 6 shows the arrangement of the invention in which the thermal interface material sheet 61 is not between the surfaces near the attachment or fixing points. Therefore the surface of the base plate 62 and the cooling surface of the cooling element 63 are against each other. As the surfaces are pressed against each other, the distance is not increased, and the 200 µm thick layer can fill the difference of 150 µm between the surfaces.

According to an embodiment of the invention, the thermal interface material layer extends to an edge of the surface of the base plate at least in one position between the attachment holes. When the material layer extend to the edge of the base plate, the positioning of the material layer is easier than in the case the edges of the material layer would be completely inside the edges of the base plate.

According to another embodiment, the thermal interface material layer extends to the edge of the surface of the base plate at least in two positions between the attachment holes. The two positions in which the material layer extends to the edge are preferably on different edges of the base plate. The surface of the base plate is typically rectangular in shape, and the edges where the material layer extends to the edges are preferably edges which are perpendicular or adjacent to each other.

According to an embodiment of the invention, the distance from an edge of the attachment hole to the edge of the thermal interface material layer is at least 3mm. The distance d between the attachment hole and the edge of the material layer is shown in Figure 1 in connection with one attachment hole. The minimum distance between the edge of the attachment hole and the edge of the thermal interface material layer is typically dependent on the type of the semiconductor module and it may differ. For example, for some power semiconductor modules the distance, which has been found giving good results, is about 5mm.

During the assembly of the cooling arrangement, the thermal interface material layer is set on top of the surface of the base plate. The layer or sheet is in correct position when the edge of the thermal interface material layer is in the same position as the edge of the base plate. If the sheet extends in many positions to the edge of the surface of the base plate, the correct placement of the sheet is easier.

In the embodiments shown in the drawings the number of the attachment holes or points is six which three holes in each longer side of the rectangular shaped base plate. However, the attachment holes can be also positioned partly in the shorter side. Further, the shape of the surface of the base plate can also be square or any other shape. The attachment holes are typically placed in the side areas of the power electronics module as the semiconductor chips are placed in more central areas of the module.

The attachment between the power semiconductor module and the cooling element is carried out using screws or bolts. The bolt is inserted through the hole of the base plate and through the corresponding hole of the cooling element and a nut is used for tightening the attachment to a suitable tightness. It is also possible that either the cooling element or the base plate has threaded holes such that the attachment may be done using a suitable screws. In the described examples the number of the attachment points, i.e. holes and corresponding screws or bolts is mentioned to be six. It is, however, understood, that the number of the attachment holes can be higher or lower than six.

The cooling element used in the invention may be of any known type. For example the cooling element may be a heat sink with cooling fins or ribs, a cold plate without any fins, liquid cooled element with channels for liquid circulation or a cooling element with heat pipes, for example.

The material of the thermal interface material layer is preferably carbon-based material, such as graphene. The thickness of the thermal interface material used in the invention is preferably in the range from 100 µm to 400 µm.

It will be obvious to a person skilled in the art that, as the technology advances, the inventive concept can be implemented in various ways. The invention and its embodiments are not limited to the examples described above but may vary within the scope of the claims.

## Claims

1. A cooling arrangement of a power semiconductor module, the arrangement comprises a power semiconductor module having a base plate, a cooling element having a cooling surface and a solid thermal interface material layer, wherein
the power semiconductor module comprises two or more attachment holes and the cooling element comprises attachment holes the positions of which correspond to the attachment holes of the power semiconductor module, the attachment holes being provided for attaching the power semiconductor module to the cooling element,
the thermal interface material layer is arranged between the base plate of the power semiconductor module and the cooling surface of the cooling element, wherein the edge of the thermal interface material layer is at a distance from the attachment holes and the thermal interface material layer has curved cut-outs in the positions of the attachment holes.

2. A cooling arrangement according to claim 1, wherein the curved cut-outs form a series of curved segments.

3. A cooling arrangement according to claim 1 or 2, wherein the thermal interface material layer extends to an edge of the surface of the base plate at least in one position between the attachment holes.

4. A cooling arrangement according to claim 3, wherein the thermal interface material layer extends to an edge of the surface of the base plate at least in two positions between the attachment holes.

5. A cooling arrangement according to claim 4, wherein the thermal interface material layer extends to adjacent edges of the surface of the base plate.

6. A cooling arrangement according to any of the previous claims 1 to 5, wherein the thermal interface material layer is intact.

7. A cooling arrangement according to any of the previous claims 1 to 6, wherein the distance from an edge of the attachment hole to the edge of the thermal interface material layer is at least 3mm.

8. A cooling arrangement according to any of the previous claims 1 to 7, wherein the material of the thermal interface material layer is carbon-based material, preferably graphene.

9. A cooling arrangement according to any of the previous claims 1 to 8, wherein the thickness of the thermal interface material layer is in range of 100 µm to 400 µm.

10. A cooling arrangement according to any of the previous claims 1 to 9, wherein the power semiconductor module comprises at least two power semiconductor switches.

11. A cooling arrangement according to any of the previous claims 1 to 10, wherein the cooling element is a heat sink with cooling fins.

12. A cooling arrangement according to any of the previous claims 1 to 11, wherein the cooling element comprises channels for liquid circulation.

13. A cooling arrangement according to any of the previous claims 1 to 11, wherein the cooling element comprises heat pipes.
